# EUROPEAN PATENT APPLICATION

(11) **EP 1 204 184 A2**
(43) Date of publication of application: **08.05.2002**
(21) Application number: 01125059.4
(22) Date of filing: 22.10.2001
(51) Int. Cl.: H01S 5/18, H01L 29/12, H01L 21/335

(54) **Electronic and photonic devices having ultra-micro structures fabricated with a focused ion beam**

(30) Priority: 02.11.2000 JP 2000336404
(71) Applicant: Katoda, Takashi, Kochi-shi, Kochi 780-8130 (JP)
(72) Inventor: Katoda, Takashi, Kochi-shi, Kochi 780-8130 (JP)
(74) Representative: Patentanwälte Leinweber & Zimmermann

(57) **Abstract**

The present invention relates to devices each of which has an ultra-micro structure formed using a focused ion beam (FIB). In many cases, the structure has a shape of plate standing itself on a substrate. Although typical examples of the devices according to the present invention are a field effect transistor and a laser diode, the present invention is not limited to only such devices. The field effect transistors and the laser diodes according to the present invention have new functions or improved characteristics.

## Description

### FIELD OF THE INVENTION

The invention relates to generally electronic and photonic devices with new functions or improved characteristics, particularly devices fabricated using a focused ion beam.

### BACKGROUND OF THE INVENTION

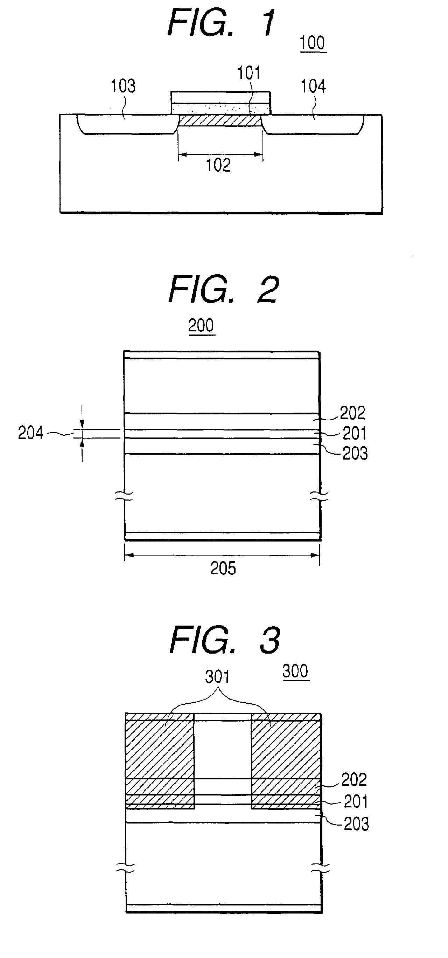

Characteristics of many kinds of electronic and photonic devices are improved by making main parts of the devices smaller. For example, Fig. 1 illustrates schematically a Metal-Oxide-Semiconductor Field Effect Transistor (MOSFET) (100). In this figure, an operation speed of a MOSFET is increased by decreasing a length (102) of the channel (101). In addition, a degree of integration per unit area is increased by decreasing an area where each device is made. Therefore, there has been constant efforts to decrease sizes of various devices in order to improve their characteristics. There is a limit to decrease sizes of devices. For example, in a device which extends along a surface such as a source (103) and a drain (104) as shown in Fig. 1, resistance of the source and the drain increases if they are made more shallow. On the other hand, there is a limit also to increase a depth of the source (103) and the drain (104) because there is a technical limit for a depth into which dopants are introduced from the surface. Further, there is a limit to decrease a channel length in order to prevent short channel effect accompanying with minimization. Thus a depth of elements of devices is strictly restricted if a device is formed with a structure which extends along a surface such as a source or a drain of a MOSFET. In particular, it is very advantageous to increase a range of a depth of a source and a drain selected depending on a specified application in a MOSFET, for example, for power application.

Fig. 2 shows schematically a main part of a laser diode (200). In the figure, an active region (201) consisting a cavity of a laser diode is a part from which light is emitted and cladding layers (202) and (203) are layers to confine both carrier and light.

A thickness (204) of the active region (201) is required to be small such as 0.2 µm on the theory of a laser diode. Because the thickness is that of a semiconductor layer, it is relatively easy to obtain such thickness. It is advantageous to decrease a width (205) of the active region (201) because a current density will be increased and a threshold of laser oscillation will be decreased by decreasing the width (205) of the active region (201). One method to decrease the width (205) of the active region (201) is to make regions surrounding the active region (201) electrically high resistive by, for example, ion implantation and restrict the area through which current flows. Fig. 3 shows an example of a laser diode (300) formed by such method. This method has a disadvantage that efficiency of the laser diode decreases and the threshold of the laser oscillation increases because a significant part of carriers are killed near the interface region with the high resistive region. The reason that carriers are killed is that the high resistive region includes a high density of defects generated by ion implantation. Therefore a method is required by which the width (205) of the active region(201) can be smaller without using ion implantation.

A laser diode has not been reported which has a function that the width (205) of the active region (201) can be controlled electrically. If the width can be controlled electrically, it is possible to modulate an amplitude of laser light without varying current which is necessary for laser oscillation. It is desirable, therefore, to realize a laser diode in which the width of the active region can be controlled electrically without varying the laser current. It is further desirable to control the width by voltage rather than current.

### SUMMARY OF THE INVENTION

The present invention relates to devices each of which has an ultra-micro structure formed using a focused ion beam (FIB). In many cases, the structure has a shape of plate standing itself on a substrate. Although typical examples of the devices according to the present invention are a field effect transistor and a laser diode, the present invention is not limited only to such devices.

### BRIEF DESCRIPTION OF THE DRAWINGS

Fig. 1 schematically illustrates a MOS field effect transistor according to the prior art.

Fig. 2 schematically illustrates a laser diode according to the prior art.

Fig. 3 schematically illustrates a laser diode in which the width of the active region is decreased according to the prior art.

Fig. 4 schematically illustrates a plate structure according to the present invention.

Fig. 5 schematically illustrates a MOSFET which includes the plate structure according to the present invention.

Fig. 6 schematically illustrates another MOSFET which includes the plate structure according to the present invention.

Fig. 7 schematically illustrates a laser diode which includes the plate structure according to the present invention.

Fig. 8 schematically illustrates another laser diode which includes the plate structure on whose side surfaces insulating films and electrodes on the insulating films are formed according to the present invention.

Fig. 9 schematically illustrates a plate structure with curved surfaces according to the present invention.

Fig. 10 schematically illustrates a laser diode which includes a plurality of the plate structures according to the present invention.

Fig. 11 schematically illustrates plate structures divided into a plurality of parts according to the present invention.

### DETAILED DESCRIPTION OF THE PRESENT INVENTION

The present invention will be fully understood by following detailed description of the specific embodiments.

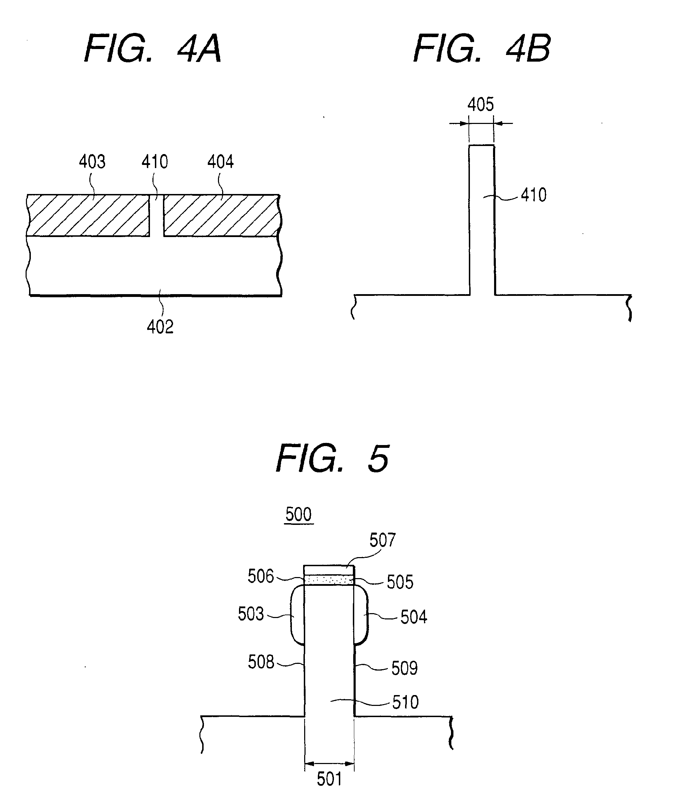

At first, general concept of the present invention is shown. Fig. 4 schematically shows a fundamental plate structure (410) which is a part of a device according to the present invention. Fig. 4(a) shows a semiconductor wafer (402) before fabrication which may comprise a plurality of layers depending on devices to be formed. A plate structure (410) standing itself shown in Fig. 4(b) is formed by removing regions (403) and (404) indicated by shaded parts in Fig. 4(a). This removal can be done by physical etching using a focused ion beam comprising, for example, gallium ions accelerated at a high voltage such as 20 kV. A thickness (405) of the plate structure (410) can be made very small such as less than 100 nm. Although in the embodiment shown above both sides of the plate structure were etched, only one side may be etched depending on a specific application.

Fig. 5 illustrates schematically a MOSFET (500) which includes a plate structure (510) as shown in Fig. 4(b). In Fig. 5, a gate insulating film (505) is formed on the top surface (506) of the plate structure (510) and a gate electrode (507) is formed on the gate insulating film (505). A source (503) and a drain (504) are formed on both surfaces (508) and (509) perpendicular to the substrate. A channel is formed along the gate insulating film by applying voltage on the gate electrode and its depth is controlled also by the voltage.

In an embodiment, the plate structure (510) was made up of silicon, the gate insulating film (505) was made up of silicon dioxide and the gate electrode (507) comprised of aluminum. The source electrode (503) and the drain electrode (504) were made up of gold. The plate structure (510) was formed by etching using a gallium-ion beam with a diameter of 0.1 µm and accelerated at 20 kV. The thickness of the plate structure was 100 nm. Therefore, the length of the channel was 100 nm which is the shortest one at present. This MOSFET is very useful as a "high speed device".

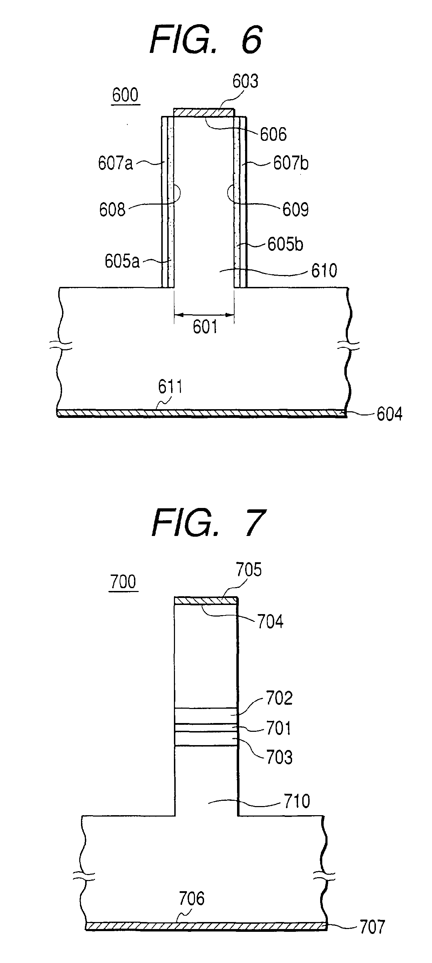

Fig. 6 shows schematically a MOSFET (600) according to another embodiment of the present invention which includes also a plate structure (610) as shown in Fig. 4(b). Insulating films (605a, 605b) are formed on both side surfaces (608) and (609) of the plate structure (610). The insulating films are gate insulators of the MOSFET. Gate electrodes (607a, 607b) are formed on each insulating film (605a, 605b). The gate electrodes (607a, 607b) are electrically connected although it is possible to control the gate separately without connecting them. A source (603) is formed on the top surface (606) of the plate structure (610). A drain electrode (604) is formed on the bottom surface (611) of the semiconductor wafer. In this case, the drain electrode is formed on the bottom surface, but it is also possible that the drain electrode is formed in the basic portion of the plate structure or in the substrate. A channel or channels of the MOSFET (600) is formed in the surface region along the gate insulator by biasing the gate electrodes when the MOSFET is an enhancement mode MOSFET. Alternately, when the MOSFET is a depletion mode one, the plate forms the channel. In both cases, a width of the channel is controlled by voltage applied to the gate electrode(s).

In an embodiment, the plate structure (610) was made up of silicon, the gate insulating films (605a, 605b) were made up of silicon dioxide and the gate electrodes (607a, 607b) were made up of aluminum. The source electrode (603) and the drain electrode (604) were made up of gold. The plate structure (610) was formed by etching using a gallium-ion beam with a diameter of 0.1 µm and accelerated at 20 kV. The thickness (601) of the plate structure (610) was 600 nm. Both inversion and depletion regions extend to a depth larger than 300 nm from the interface between the plate structure (610) and the insulating films (605a, 605b) by applying voltage to the gate electrodes (607a, 607b) when the semiconductor is silicon. They extend from both side surfaces (608, 609) of the plate structure (610). Therefore, the width of the channel can be changed from 0 to 600 nm in the embodiment. A depth of the channel, that is a length along the source (603) and perpendicular to the width of the channel, can be selected depending on a specified application. For example, a larger depth will be selected if it is necessary to flow a larger current. Therefore, this MOSFET is very useful as a MOSFET for power use.

The plate structure according to the present invention can be used in many devices including CMOS devices and semiconductor on an insulator (SOI) devices. The structure is also advantageously used to form photonic devices including laser diodes and light emitting diodes. The devices including the plate structure according to the present invention have new functions or improved characteristics.

Fig. 7 shows schematically a laser diode (700) which includes a plate structure (710) standing itself on a substrate according to the third embodiment of the present invention. In the figure, the active region (701) comprises of Gallium Arsenide (GaAs) having a thickness of 0.2 µm and the cladding layers (702) and (703) comprise of Aluminum Gallium Arsenide (Al_{0.2} Ga_{0.8}As). Electrodes (705) and (707) are formed on the top surface (704) and the bottom surface (706), respectively. As well known to one skilled in the art, various layers are included in the laser diode (700) other than the active region (701) and the cladding layers (702) and (703). For example layers which promote formation of electrodes and buffer layers which decrease defects are included. Because they are not essential to explain the present invention, detailed description is not given here. It is advantageous to cover the both side surfaces of the plate structure (710) by suitable material such as dielectric films in order to protect the surfaces.

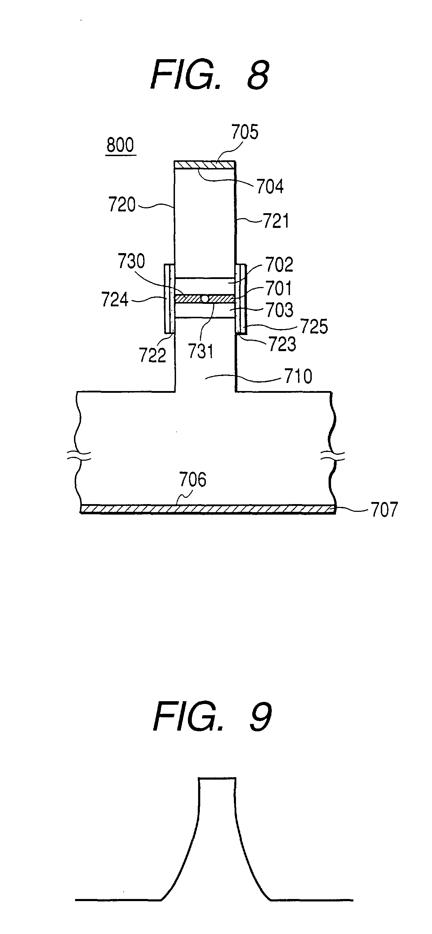

Fig.8 schematically shows another laser diode (800) according to the fourth embodiment of the present invention. The laser diode (800) includes insulating films (722) and (723) formed on the both side surfaces (720) and (721). In addition, electrodes (724) and (725) are formed on the insulating films (722) and (723), respectively. When voltage is applied to the electrodes, inversion regions (730) and (731) extend into the active region (701). Therefore, the width of the active region (701) decreases. That is, the width can be controlled by voltage applied to the electrodes. This phenomena can be applied to modulate intensity of the light generated from the laser diode (800).

Although the electrodes (724) and (725) were formed on the insulating films (722) and (723) in the embodiment shown in Fig. 8, metal films can be formed directly on the side surfaces (720) and (721) of the semiconductor if the metal film forms Shottky contacts with the semiconductors which form the active region (701) and the cladding layers (702) and (703).

In an embodiment, the insulating film comprised of silicon nitride and the electrodes were formed of aluminum.

Although the plate structures have been shown to have surfaces parallel one another in the embodiment shown above, they can have curved surfaces. Fig. 9 shows schematically an example of such structure.

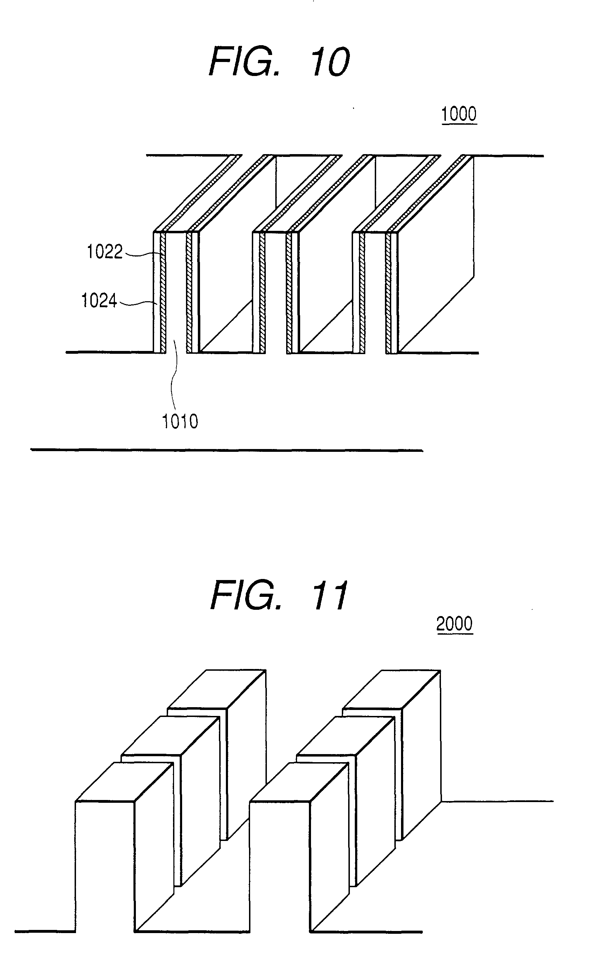

Furthermore, although the devices shown above include only one of the plate structure, devices including a plurality of the plate structures can be formed. Fig. 10 shows an example of such devices. In the figure, a laser diode (1000) is shown to include a plurality of laser diode (800) shown in Fig. 8 such that one end portions of each laser diode are contiguous and form finger structures. Insulating films, for example (1022), are formed on the side surfaces of each finger (1010) and electrodes, for example (1024), are formed on the insulating films. Laser light emitted from each laser diode can be controlled by voltage applied to the electrode on each finger.

Furthermore, it is possible to divide the plate structure along the direction of length using a focused ion beam. Fig. 11 shows schematically an example of such structures (2000). Each region can be formed such that electrons in the region are quantized. That is, the region is a so-called "quantum box". Devices having new functions or improved characteristics will be realized using such quantum boxes. For example, a new laser diode is expected using quantum dots. However, it is difficult to control precisely a shape and a size of quantum dots by techniques previously reported. On the other hand, a shape and a size of the quantum box can be controlled precisely and reproducibly for devices according to the present invention.

It is understood that the above-described embodiments are illustrative of only a few of the many possible specific embodiments, which can represent applications of the invention. Numerous and varied other arrangements can be made by those skilled in the art without departing from the spirit and scope of the invention.

## Claims

1. Electronic and photonic devices having an ultra-micro structure formed by etching using a focused ion beam.

2. Electronic devices having a micro-plate structure of semiconductor material formed by etching using a focused ion beam.

3. A field effect transistor formed on a micro-plate structure fabricated by using a focused ion beam, wherein the channel length or/and the channel width is controlled by the thickness, the width or the height of said plate structure.

4. The field effect transistor according to claim 3, wherein said plate structure has at least one electrode on each side surface and a channel is formed between said electrodes.

5. A field effect transistor formed on a micro plate structure fabricated by using a focused ion beam, the transistor further comprising;
an insulating film or films on one or both side surface(s) of said plate structure;
at least one electrode formed on said insulating film on said at least one side surface of said plate structure;
electrodes formed on the top and the bottom surfaces, respectively, of said plate structure; and
at least one channel is formed along said side surface(s) between said electrodes on the top and the bottom surfaces.

6. The field effect transistor according to claim 5 wherein the width of said channel is controlled by voltage applied on said at least one electrode on said side surface.

7. Photonic devices having a micro-plate structure formed by etching using a focused ion beam.

8. A laser diode having a micro-plate structure formed by etching using a focused ion beam which includes at least one active region and at least one cladding layer.

9. The laser diode according to claim 8, wherein the width of said active region is defined by the width of said plate structure.

10. A laser diode comprising:
a micro-plate structure formed by etching using a focused ion beam;
at least one active region and at least one cladding layer in said plate structure;
electrodes formed on the top and the bottom surfaces of said plate structure; and
electrodes on at least one side surface of said plate structure.

11. The laser diode according to claim 10, wherein said electrodes on said at least one side surface forms Shottky contacts with said active region and said cladding layer.

12. A laser diode comprising:
a micro-plate structure formed by etching using a focused ion beam;
at least one active region and at least one cladding layer in said plate structure;
electrodes formed on the top and the bottom surfaces of said plate structure;
at least one insulating film on at least one side surface of said plate structure; and
electrodes on said at least one insulating film.

13. The laser diode according to claim 10, 11 or 12 wherein intensity of light emitted from said laser diode is controlled by voltage applied on said at least one electrode on said at least one side surface.

14. A device having structure formed by dividing a plate structure(s) with etching using a focused ion beam, the plate structure(s) formed by etching using a focused ion beam.

15. The devices according to claim 14, wherein electrons in said divided structures are quantized.
